# EUROPÄISCHE PATENTSCHRIFT

(11) **EP 2 141 131 B1**
(45) Veröffentlichungstag und Bekanntmachung des Hinweises auf die Patenterteilung: **12.10.2016**
(21) Anmeldenummer: 09158576.0
(22) Anmeldetag: 23.04.2009
(51) Int. Cl.: C03B 19/09

(54) **VERFAHREN ZUR HERSTELLUNG EINES QUARZGLASTIEGELS**
METHOD OF PRODUCING A QUARTZ GLASS CRUCIBLE
PROCÉDÉ DE FABRICATION D'UN CREUSET DE SILICE VITREUSE

(30) Priorität: 30.06.2008 DE 102008030310
(43) Veröffentlichungstag der Anmeldung: 06.01.2010
(73) Patentinhaber: Heraeus Quarzglas GmbH & Co. KG, 63450 Hanau (DE)
(72) Erfinder: Lehmann, Walter, 04155 Leipzig (DE); Hofmann, Achim, 60599 Frankfurt (DE); Kayser, Thomas, 04105 Leipzig (DE)
(74) Vertreter: Staudt, Armin Walter

(56) Entgegenhaltungen:
- EP-A2- 0 319 031
- WO-A1-02/16677
- US-A- 4 632 686

## Beschreibung

Die Erfindung betrifft ein Verfahren zur Herstellung eines Quarzglastiegels zum Ziehen eines Einkristalls, das folgende Verfahrensschritte umfasst:
(a) Bereitstellen einer Schmelzform mit einer Wandung, die eine Innenseite, eine Außenseite und durchgehende Löcher zwischen Außenseite und Innenseite aufweist,
(b) Bereitstellen einer Außenschichtkörnung aus ersten, gröberen SiO₂-Teilchen und Ausbilden einer Außenkörnungsschicht aus der Außenschichtkörnung an der Innenseite der Schmelzform-Wandung,
(c) Bereitstellen einer Sperrschichtkörnung aus zweiten, feineren SiO₂-Teilchen und Erzeugen einer Sperrkörnungsschicht aus der Sperrschichtkörnung auf der Außenkörnungsschicht, mit einer Maßnahme zur Fixierung der Sperrschichtkörnung auf der Außenschichtkörnung,
(d) Anlegen eines Unterdrucks an der Außenseite der Schmelzform-Wandung,
(e) Erhitzen der Sperrkörnungsschicht und der Außenkörnungsschicht unter Bildung eines Quarzglastiegels mit transparenter Innenschicht.

### Stand der Technik

Quarzglastiegel werden zur Aufnahme der Metallschmelze beim Ziehen von Einkristallen nach dem sogenannten Czochralski-Verfahren eingesetzt. Ihre Herstellung erfolgt üblicherweise, indem an der Innenwandung einer metallischen Schmelzform eine Schicht aus SiO₂-Körnung erzeugt und diese unter Einsatz eines Lichtbogens (Plasma) erhitzt und dabei zu dem Quarzglastiegel gesintert wird. Die Wandung des so erzeugten Quarzglastiegels wird in der Regel aus einer transparenten Innenschicht und einer opaken Außenschicht gebildet.

Die transparente Innenschicht steht beim Ziehprozess im Kontakt zur Siliziumschmelze und unterliegt hohen mechanischen, chemischen und thermischen Belastungen. In der Innenschicht verbliebene kleine Restblasen wachsen unter dem Einfluss von Temperatur und Druck und können schließlich zerplatzen, wodurch Bruchstücke und Verunreinigungen in die Siliziumschmelze gelangen und dadurch eine geringere Ausbeute an versetzungsfreiem Silizium-Einkristall erzielt wird.

Um den korrosiven Angriff der Siliziumschmelze zu verringern und damit einhergehend die Freisetzung von Verunreinigungen aus der Tiegelwandung zu minimieren, ist die Innenschicht daher möglichst homogen und blasenarm. Zur Verbesserung dieser Eigenschaften sind Tiegelherstellungsverfahren mit vakuumunterstützter Ausbildung der Innenschicht bekannt. Dabei wird eine Vakuum-Schmelzform eingesetzt, deren Wandung porös ist oder die mit einer Vielzahl durchgehender Bohrungen versehen ist, so dass bei Anlegen eines Unterdrucks an der Schmelzformaußenseite Gase aus der SiO₂-Körnungsschicht nach außen abgezogen werden können.

Ein Vakuum-Herstellungsverfahren gemäß der eingangs genannten Gattung ist aus der US 4,632,686 A bekannt. Hierbei wird in eine Vakuum-Schmelzform zunächst eine Schicht aus grobem Quarzpulver mit Teilchendurchmessern im Bereich von 100 bis 300 µm gegeben und zu einer Außenkörnungsschicht an der Innenwandung geformt. Auf die Innenseite der Außenkörnungsschicht wird eine Innenkörnungsschicht aufgebracht, die aus einem feineren Quarzglaspulver besteht. Die Durchmesser der Pulverteilchen liegen im Bereicht zwischen 44 und 120 µm, also im geometrischen Mittel bei Teilchengröße um 80 µm. Infolge der vergleichsweise hohen Packungsdichte der feineren Pulverteilchen lassen diese beim Anlegen von Vakuum von der Außenseite der Schmelzform her weniger Luft passieren und wirken insoweit als Sperrschicht, die es ermöglicht, ein stärkeres Vakuum zu erzeugen, was wiederum zu einer effektiveren Entfernung von eingeschlossenen Gasen aus den Körnungsschichten beiträgt. Auf diese Weise wird erreicht, dass beim Sintern der Körnungsschichten von Innen aus - durch Einführen einer Plasmaquelle in den Innenraum der Schmelzform - das feinteilige Quarzglaspulver zuerst aufschmilzt und dabei eine dichte Glasschicht bildet. Sobald die Glasschicht erzeugt ist, kann der Unterdruck noch weiter erhöht werden. Erst unter dem Einfluss dieses erhöhten Vakuums ist das Erschmelzen einer wirklich blasenarmen Innenschicht möglich.

Die davor erzeugte Glasschicht ist zwar dicht, enthält jedoch noch - mangels ausreichend hohen Vakuums - eine Vielzahl von Blasen. Diese zwar dichte aber nicht blasenfreie Schicht wird hier als "Versiegelungsschicht" bezeichnet. Die blasenhaltige Versiegelungsschicht muss vor dem bestimmungsgemäßen Einsatz des Quarzglastiegels entfernt werden. Um den Aufwand dafür gering zu halten, ist eine möglichst dünne Versiegelungsschicht erwünscht. Es zeigt sich außerdem, dass die Versiegelungsschicht lokal unterschiedlich dick ausgebildet sein kann. Dies erschwert das Entfernen ohne eine Beeinträchtigung der darunter liegenden blasenfreien Schicht. So werden beispielsweise zum vollständigen Abätzen dicker Bereiche der Versiegelungsschicht nicht nur die dünneren Schichtbereichen der Versiegelungsschicht entfernt, sondern auch die darunter liegenden Bereiche der blasenfreien Innenschicht lokal abgetragen. Außerdem kommt es infolge von lokalen Unterschieden bei der Erzeugung der Versiegelungsschicht leicht zu Inhomogenitäten, insbesondere im Übergangsbereich zwischen Boden und Seitenwandung des Tiegels, die sich bei der anschließenden Herstellung der blasenfreien Innenschicht bemerkbar machen.

### Technische Aufgabe

Der Erfindung liegt daher die Aufgabe zugrunde, das eingangs genannte Verfahren dahingehend zu verbessern, dass eine möglichst dünne und gleichmäßige Versiegelungsschicht und damit einhergehend auch eine homogene Innenschicht reproduzierbar erzeugt werden kann.

Diese Aufgabe wird ausgehend von dem Verfahren der eingangs genannten Gattung erfindungsgemäß dadurch gelöst, dass die SiO₂-Teilchen der Sperrschichtkörnung eine mittlere Teilchengröße (D₅₀-Wert) von weniger als 30 µm aufweisen und dass das Ausbilden der Sperrkörnungsschicht die Maßnahme zur Fixierung der Sperrschichtkörnung auf der Außenkörnungsschicht ein Anfeuchten der Außenkörnungsschicht vor oder beim Erzeugen der Sperrkörnungsschicht und/oder ein Anfeuchten der Sperrschichtkörnung umfasst.

An der Schmelzform-Wandung wird eine Außenkörnungsschicht erzeugt, die aus relativ grobkörniger Außenschichtkörnung besteht. Diese Art der SiO₂-Körnung mit mittleren Teilchengrößen von mehr als 50 µm wird im Folgenden auch als "grobe Körnung" oder "Grobkörnung" bezeichnet. Zwischen der Außenkörnungsschicht und der Wandung der Schmelzform können eine oder mehrere weitere SiO₂-Körnungsschichten vorgesehen sein.

Unmittelbar auf der Außenkörnungsschicht wird eine Sperrkörnungsschicht aus Sperrschichtkörnung aufgebracht, die feinteilige SiO₂-Teilchen enthält. Diese Art der SiO₂-Körnung mit mittleren Teilchengrößen von weniger als 30 µm wird im Folgenden auch als "feine Körnung" oder "Feinkörnung" bezeichnet. Die Sperrkörnungsschicht bildet die innerste Körnungsschicht.

Beim Aufbringen der Sperrschichtkörnung oder danach wird ein Unterdruck an der Außenseite der Schmelzform-Wandung angelegt, der wegen der Porosität der Körnungsschichten in den Innenraum der Schmelzform durchgreift und daher das dort enthaltene Gas durch die Körnungsschichten abgesaugt wird.

Die Körnungsschichten werden anschließend erhitzt. Das Erhitzen der Körnungsschichten erfolgt in der Regel unter der Einwirkung eines Lichtbogens, wie aus dem Stand der Technik bekannt. Im Verlauf dieses Erhitzungsvorgangs werden die SiO₂-Körnungsschichten zu dem Quarzglastiegel mit opaker Außenschicht und transparenter Innenschicht gesintert. Die transparente Innenschicht wird dabei aus verglaster Feinkörnung und/oder aus anderer SiO₂-Körnung gebildet.

Beim erfindungsgemäßen Verfahren wird eine Sperrschichtkörnung eingesetzt, die sich durch eine geringe mittlere Teilchengröße von weniger als 30 µm auszeichnet. Diese feinteilige Körnung wirkt nicht nur als mechanische Sperrschicht, indem sie beim Anlegen eines Vakuums an der Schmelzform-Außenwandung das Einsaugen von Atmosphäre aus dem Schmelztiegel-Innenraum behindert, sondern sie zeichnet sich insbesondere durch eine hohe Sinteraktivität aus.

Die hohe Sinteraktivität führt dazu, dass die Sperrschichtkörnung besonders gleichmäßig - das heißt ohne lokale Inhomogenitäten - bei vergleichsweise niedriger Temperatur und kurzer Heizdauer zu einer dichten, glasigen Versiegelungsschicht sintert. Diese Versiegelungsschicht bildet sich somit gleichmäßig über der gesamten Tiegel-Innenwandung aus und ermöglicht so das rasche Anlegen eines stärkeren Vakuums, was beim weiteren Sintern die Blasendichte der tiefer liegenden Schichten reduziert.

Die Mindestdicke der Versiegelungsschicht ergibt sich bei gegebener Leistung des Lichtbogens aufgrund derjenigen Heizdauer, die zum vollständigen Versiegeln der Sperrkörnungsschicht erforderlich ist. Wegen der hohen Sinteraktivität der Sperrschichtkörnung kommt es zu einer gleichmäßigen und schnellen vollständigen Versiegelung der Oberfläche, so dass das stärkere Vakuum relativ frühzeitig angelegt und die Stärke der mit geringem Vakuum erzeugten, blasenhaltigen Versiegelungsschicht relativ gering gehalten werden kann.

Die hohe Sinteraktivität der Feinkörnung wird durch deren Feinteiligkeit und die damit einhergehende hohe spezifische BET-Oberfläche erreicht. Diese Eigenschaften erschweren aber andererseits die Handhabung bei den üblichen Prozessbedingungen der Tiegelherstellung oder machen sie sogar unmöglich. Insbesondere kommt es leicht zu einem Verblasen der feinteiligen Körnung unter dem Einfluss des Lichtbogendrucks und durch Gasströme und thermische Konvektion im Innenraum der Schmelzform, was die Herstellung einer Sperrkörnungsschicht mit gleichmäßiger Dicke erschwert.

Eine weitere Herausforderung beim erfindungsgemäßen Verfahren besteht daher darin, die feinteilige Sperrschichtkörnung an der Außenkörnungsschicht zu fixieren, um sie dadurch weitgehend als gleichmäßige Schicht gewünschter Dicke zu immobilisieren. Nur durch eine weitgehende Immobilisierung der Körnung ist die Ausbildung einer Sperrkörnungsschicht mit gleichmäßiger Dicke erreichbar. Die Immobilisierung wird vorzugsweise durch eine Verstärkung der Adhäsionskräfte zwischen den Teilchen der Sperrschichtkörnung und der Außenkörnungsschicht erreicht.

Eine Maßnahme zur Fixierung der Sperrschichtkörnung umfasst ein Anfeuchten der Außenkörnungsschicht vor oder beim Erzeugen der Sperrkörnungsschicht.

Das Anfeuchten der Außenkörnungsschicht bewirkt eine Erhöhung von Adhäsionskräften in Bezug auf die darauf aufgebrachte Sperrschichtkörnung, was zu deren Immobilisierung in Form einer Sperrkörnungsschicht beiträgt. Die Außenkörnungsschicht wird entweder aus angefeuchteter Außenschichtkörnung hergestellt oder sie wird vor dem Aufbringen der Sperrschichtkörnung befeuchtet, etwa durch Aufsprühen einer Flüssigkeit, wie etwa Wasser oder Alkohol. Die Befeuchtung kann aber auch während des Aufbringens der Sperrschichtkörnung erfolgen.

Alternativ oder ergänzend dazu umfasst die Maßnahme zur Fixierung der Sperrschichtkörnung ein Anfeuchten der Sperrschichtkörnung selbst.

Die Sperrschichtkörnung wird in der Regel nur geringfügig angefeuchtet, so dass sich ein Feuchtigkeitsgehalt von weniger als 4 % ergibt. Alternativ dazu kann die Sperrschichtkörnung beispielsweise in einer Suspension aufgenommen oder dispergiert in einem Kieselsäure-Gel auf die Außenkörnungsschicht aufgetragen werden. Das Anfeuchten der Sperrschichtkörnung kann vor, beim oder nach dem Erzeugen der Sperrkörnungsschicht erfolgen. Diese Maßnahme hat gegenüber dem Befeuchten der Außenkörnungsschicht den Vorteil, dass die Feuchtigkeit nur oberflächennah eingebracht wird, und daher im Verlauf des Tiegelherstellungsprozesses leichter wieder entfernt werden kann.

Erst das Zusammenspiel zwischen einer gleichmäßigen und vorzugsweise dünnen Sperrkörnungsschicht und der hohen Sinteraktivität der sie bildenden SiO₂-Körnung ermöglicht somit die Ausbildung der gewünschten, gleichmäßig dünnen Versiegelungsschicht. Dadurch, dass die an die Sperrkörnungsschicht unmittelbar angrenzende Außenkörnungsschicht aus gröberen SiO₂-Teilchen besteht, ergibt sich beim Fortschreiten der Sinterfront von Innen nach Außen ein merklicher Abfall in der Sinteraktivität, so dass die Dicke der Versiegelungsschicht auf Basis der Dicke der Sperrkörnungsschicht genau vorgegeben werden kann.

Eine besonders hohe Sinteraktivität der Sperrschichtkörnung wird erreicht, wenn die SiO₂-Teilchen der Sperrschichtkörnung eine mittlere Teilchengröße (D₅₀-Wert) von weniger als 20 µm aufweisen.

Mittlere Teilchengrößen von weniger als 1 µm sind jedoch nicht bevorzugt, da derartig feine Teilchen abgesehen von der oben erläuterten Problematik des leichten Verblasens auch zu Agglomeratbildung neigen, was ihre Verarbeitung zu einer gleichmäßigen Sperrkörnungsschicht zusätzlich erschwert. Die Ermittlung des D₅₀-Wertes der Teilchengrößenverteilung erfolgt nach DIN 725-5 (2007-04).

Die SiO₂-Teilchen der Außenschichtkörnung weisen bevorzugt eine mittlere Teilchengröße (D₅₀-Wert) von mehr als 100 µm, besonders bevorzugt eine mittlere Teilchengröße (D₅₀-Wert) von mehr als 120 µm, auf.

Die erleichtert in erster Linie die Handhabung der Körnung beim Tiegel-Herstellungsprozess. Außerdem ergibt sich dadurch ein deutlicher Unterschied zwischen den Sinteraktivitäten der SiO₂-Körnungen der Sperrkörnungsschicht und der an sie angrenzenden Außenkörnungsschicht.

Weiterhin hat es sich als günstig erwiesen, wenn die SiO₂-Teilchen der Sperrschichtkörnung eine mehrmodale Teilchengrößenverteilung aufweisen, mit einem ersten Maximum der Größenverteilung im Bereich von 0,03 bis 2 µm und einem zweiten Maximum im Bereich von 3 bis 50 µm.

Die SiO₂-Teilchen der Sperrschichtkörnung liegen dabei in einer Teilchengrößenverteilung vor, die zwei oder mehr Maxima aufweist. Mindestens eines der Maxima - und zwar ein Nebenmaximum - liegt im feinteiligen Bereich mit Teilchendurchmessern unterhalb von 2 µm, ein weiteres Maximum - und zwar das Hauptmaximum - liegt im grobkörnigen Bereich mit Teilchendurchmessern oberhalb von 3 µm. Eine derartige mehrmodale Teilchengrößenverteilung mit mindestens zwei Körnungsverteilungen, die sich in ihrer mittleren Größe deutlich voneinander unterscheiden, erleichtert die Einstellung einer hohen Packungsdichte der Körnungsschicht (hohe Schütt- oder Rütteldichte), was - unterstützt durch den besonders feinteiligen Anteil der Körnung - zu der gewünschten hohen Sinteraktivität wesentlich beiträgt. Denn kleine SiO₂-Teilchen (im µm-Bereich) haben eine relativ große spezifische äußere Oberfläche, mit BET-Werten zwischen 1 und 20 m²/g. Dadurch wird die Sinteraktivität der Sperrkörnungsschicht verbessert, so dass bereits durch Sintern bei vergleichsweise geringer thermischer Belastung (niedrigere Sintertemperatur und/oder kürzere Sinterdauer) eine geschlossenporige Oberfläche erzeugt wird. Dies gilt insbesondere auch für SiO₂-Teilchen mit Teilchengrößen im Nanometerbereich (<100 nm, mit BET-Oberflächen von mehr als 40 m²/g), wie sie beispielsweise als pyrogener Soot bei der Herstellung von synthetischem Quarzglas durch Oxidation oder Flammenhydrolyse von siliziumhaltigen Ausgangssubstanzen anfallen. Allerdings bewirken derartig kleine Teilchen in großer Menge eine vergleichsweise starke Schwindung beim Sintern der Körnungsschicht, was zur Rissbildung führen kann. Daher ist deren Gewichtsanteil in der SiO₂-Körnungsschicht auf maximal 20 % begrenzt.

Es hat sich außerdem als günstig erwiesen, wenn der Sperrschichtkörnung ein die Viskosität von Quarzglas verringernder Dotierstoff zugesetzt wird.

Dabei wird die Erweichungstemperatur der SiO₂-Körnung durch die Zugabe eines oder mehrere Dotierstoffe gesenkt, was zu einer besonders raschen Verdichtung der Körnungsschicht beim Erhitzen führt. Im Fall, dass die dotierte Körnung ausschließlich für die Ausbildung der Versiegelungsschicht eingesetzt und diese vor dem bestimmungsgemäßen Einsatz des Quarzglastiegels entfernt wird, enthält die resultierende blasenfreie Innenschicht de Dotierstoff nicht.

Im einfachsten Fall wird zum Anfeuchten der Außenkörnungsschicht und/oder der Sperrschichtkörnung Wasserdampf eingesetzt. Wasser bewirkt eine merkliche Verstärkung der Adhäsionskräfte zwischen den Körnungsteilchen und hat bei einem Einsatz zur Befeuchtung der Sperrschichtkörnung den weiteren Vorteil, dass es deren Viskosität herabsetzt, was das Erzeugen einer dichten Versiegelungsschicht erleichtert. Andererseits ist darauf zu achten, dass der Hydroxylgruppengehalt der oberflächennahen Schichten des Quarzglastiegels, insbesondere der blasenfreien Innenschicht, nicht zu hoch wird, da ansonsten die thermische Stabilität des Quarzglastiegels leidet.

Im Hinblick hierauf hat sich eine Verfahrensweise als günstig erwiesen, bei der zum Anfeuchten eine wasserfreie Flüssigkeit eingesetzt wird.

Hierdurch wird der Eintrag von Hydroxylgruppen und damit die Gefahr einer merklichen Verminderung der thermischen Stabilität des Quarzglastiegels verringert. Als wasserfreie beziehungsweise als hydroxylfreie Flüssigkeiten kommen beispielsweise organische Flüssigkeiten in Betracht.

Weiterhin hat sich eine Maßnahme zur Fixierung der Sperrschichtkörnung als günstig erwiesen, die ein Aufbringen von Sperrschichtkörnung auf einem flexiblen, flächigen Hilfskörper und ein Fixieren auf dem Hilfskörper umfasst, der anschließend mit der darauf fixierten Sperrschichtkörnung auf die Außenkörnungsschicht aufgelegt wird.

Die Sperrschichtkörnung wird hier beispielsweise in Form einer flüssigen Suspension oder einer pastösen Masse bereitgestellt und auf einem flexiblen Flächengebilde in vorgegebener Schichtstärke aufgetragen. Bei dem Flächengebilde handelt es sich beispielsweise um konglomerat-, netz- oder gitterartige Anordnungen von Fasern, Streifen oder Garnen. Nach dem Beschichten des Flächengebildes - und gegebenenfalls einem Trocknen der Beschichtungsmasse - wird es auf der Außenkörnungsschicht aufgelegt. Das Flächengebilde kann beispielsweise aus Quarzglas bestehen; vorzugsweise besteht es aber aus Zellulose und wird im weiteren Tiegel-Herstellungsprozess verascht.

Es wird eine Verfahrensweise bevorzugt, bei der das Erhitzen gemäß Verfahrensschritt (e) einen zweistufigen Heizprozess umfasst, mit einer ersten Heizstufe, während der die Sperrkörnungsschicht bei niedrigerer Temperatur verglast wird, und mit einer zweiten Heizstufe, während der die Außenkörnungsschicht bei höherer Temperatur erhitzt und dabei mindestens teilweise gesintert wird.

Infolge der hohen Sinteraktivität setzt das Verglasen der Sperrschichtkörnung bereits bei einer Temperatur ein, die so niedrig ist, dass die daran angrenzende Grobkörnung noch porös und damit gasdurchlässig bleibt. Dadurch wird eine Versiegelungsschicht mit definierter, dünner Wandstärke auf einem durchgehend weiterhin porösen Untergrund erzeugt. Da nur die sinteraktive Sperrschichtkörnung sintert, besteht die Versiegelungsschicht vollständig aus gesinterter Sperrschichtkörnung und zwar mit einer Schichtdicke, die durch die Sperrschichtkörnungsschicht vorgegeben wird. Nach Ausbildung der dichten Versiegelungsschicht wird die Stärke des Vakuums erhöht, so dass Gase aus der noch vollständig porösen Außenkörnungsschicht entfernt werden, und in der zweiten Heizstufe wird daraufhin die Außenkörnungsschicht bei höherer Temperatur gesintert.

Dabei hat es sich als günstig erwiesen, wenn der Übergang von der ersten zur zweiten Heizstufe nach dem vollständigen Verglasen der Sperrkörnungsschicht erfolgt.

Dadurch ergibt sich eine definierte Stärke der Versiegelungsschicht.

Im Hinblick auf eine einerseits zwar gasdichte, andererseits aber möglichst dünne Versiegelungsschicht wird eine Verfahrensweise bevorzugt, bei der die Sperrkörnungsschicht mit einer Schichtdicke im Bereich von 0,3 mm bis 5 mm, vorzugsweise mit einer Schichtdicke von weniger als 3 mm, erzeugt wird.

Bei einer relativen Dichte der Sperrkörnungsschicht von etwa 80 % (bezogen auf die Dichte von Quarzglas) ergeben sich nach dem Sintern der Sperrkörnungsschicht Dicken für die Versiegelungsschicht im Bereich von etwa 0,2 mm bis 4 mm, vorzugsweise weniger als 2,4 mm.

Eine auf der Innenwandung des Quarzglastiegels vorhandene, blasenhaltige SiO₂-Versiegelungsschicht wird vorzugsweise durch Abbrennen mittels Plasma entfernt.

Durch das Abbrennen der Versiegelungsschicht mittels Plasma während des Tiegel-Herstellungsprozesses wird ein zusätzlicher Arbeitsschritt vermieden, wie etwa beim Entfernen der Versiegelungsschicht durch Sandstrahlen oder durch chemisches Ätzen.

### Ausführungsbeispiel

Die Erfindung wird nachfolgend anhand von Ausführungsbeispielen und einer Zeichnung näher erläutert. Es zeigt
- **Figur 1**: in schematischer Darstellung eine Schmelzvorrichtung zur Durchführung des erfindungsgemäßen Verfahrens beim Verfahrensschritt des Verglasens der Wandung des Quarzglastiegels,
- **Figur 2**: den Ausschnitt "A" der Wandung des Quarzglastiegels aus Figur 1 nach Ausbilden der Versiegelungsschicht in vergrößerte Darstellung, und
- **Figur 3**: ein Diagramm der SiO₂-Teilchengrößenverteilung einer Rohstoffkomponente für den Einsatz beim erfindungsgemäßen Verfahren.

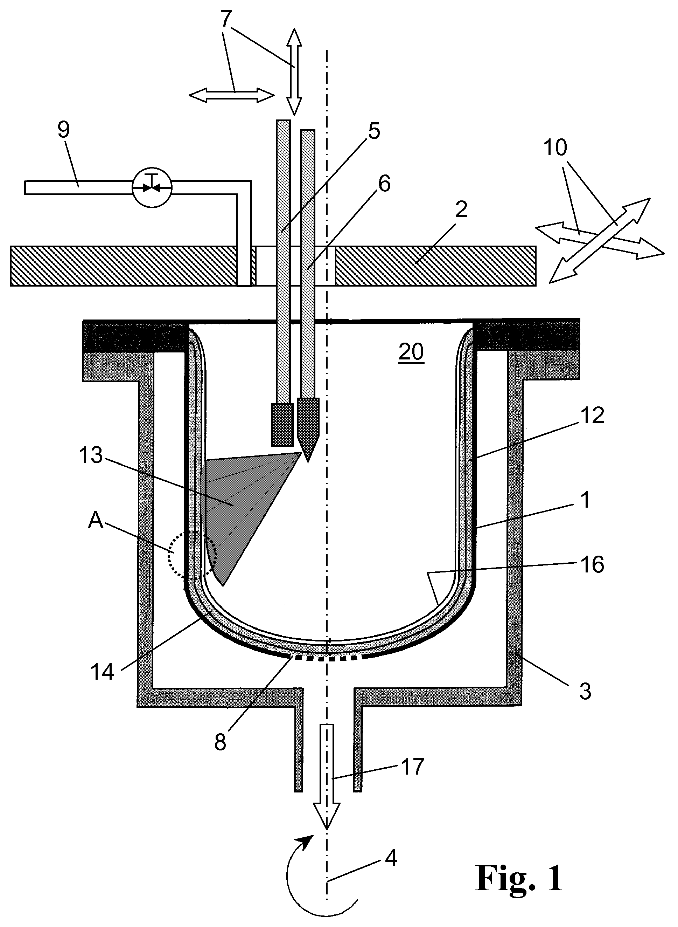

Die Schmelzvorrichtung gemäß **Figur 1** umfasst eine Schmelzform 1 aus Metall mit einem Innendurchmesser von 75 cm, die mit einem Außenflansch auf einem Träger 3 aufliegt. Der Träger 3 ist um die Mittelachse 4 rotierbar. In den Innenraum 20 der Schmelzform 1 ragen eine Kathode 5 und eine Anode 6 (Elektroden 5; 6) aus Grafit, die - wie anhand der Richtungspfeile 7 angedeutet - innerhalb der Schmelzform 1 in allen Raumrichtungen verfahrbar sind.

Die offene Oberseite der Schmelzform 1 wird von einem Hitzeschild 2 in Form einer wassergekühlten Metallplatte mit einer Dicke von 10 mm überragt, die eine zentrale Durchgangsbohrung aufweist, durch die hindurch die Elektroden 5, 6 in die Schmelzform 1 hineinragen. Der Hitzeschild 2 ist mit einem Gaseinlass 9 für Wasserdampf verbunden. Zwischen der Schmelzform 1 und dem Hitzeschild 2 ist ein Entlüftungsspalt mit einer Weite von 50 mm vorgesehen (Fig. 1 zeigt diese Abmessung und alle anderen Abmessungen der Vorrichtung nur schematisch, nicht maßstäblich). Der Hitzeschild 2 ist in der Ebene oberhalb der Schmelzform 1 horizontal verfahrbar (in x- und y-Richtung), wie dies die Richtungspfeile 10 andeuten.

Der Raum zwischen dem Träger 3 und der Schmelzform 1 ist mittels einer Vakuumeinrichtung, die durch den Richtungspfeil 17 repräsentiert wird, evakuierbar. Die Schmelzform 1 weist eine Vielzahl von Durchlässen 8 auf (diese sind in Figur 1 nur symbolisch im Bodenbereich angedeutet), über die das an der Außenseite der Form 1 anliegende Vakuum 17 nach Innen durchgreifen kann.

Im Folgenden wird die Herstellung eines 28-Zoll-Quarzglastiegels gemäß der Erfindung anhand eines bevorzugten Ausführungsbeispiels näher erläutert.

In einem ersten Verfahrensschritt wird kristalline Körnung aus natürlichem, mittels Heißchlorierung gereinigtem Quarzsand, mit einer Korngröße im Bereich von 90 µm bis 315 µm in die um ihre Längsachse 4 rotierende Schmelzform 1 eingefüllt. Unter der Wirkung der Zentrifugalkraft und mittels einer Formschablone wird an der Innenwandung der Schmelzform 1 eine rotationssymmetrische tiegelförmige Körnungsschicht 12 aus mechanisch verfestigtem Quarzsand geformt. Die mittlere Schichtdicke der Körnungsschicht 12 beträgt etwa 12 mm.

In einem zweiten Verfahrensschritt wird auf der Innenwandung der Quarzsand-Schicht 12 eine Innenkörnungsschicht 14 aus synthetisch hergestelltem Quarzglaspulver ebenfalls unter Einsatz einer Formschablone und unter anhaltender Rotation der Schmelzform 1 ausgeformt. Das synthetische Quarzpulver hat Teilchengrößen im Bereich von 50 bis 120 µm, wobei die mittlere Teilchengröße bei etwa 85 µm liegt. Die mittlere Schichtdicke der Innenkörnungsschicht 14 beträgt ebenfalls etwa 12 mm.

Die Körnungsschicht 12 und die Innenkörnungsschicht 14 bilden zusammen eine "Außenkörnungsschicht" im Sinne dieser Erfindung. Auf der Außenkörnungsschicht (12; 14) wird in einem dritten Verfahrensschritt - ebenfalls unter Einsatz einer Formschablone und unter anhaltender Rotation der Schmelzform 1 - eine weitere SiO₂-Körnungsschicht (16) mit einer mittleren Dicke um 3 mm aus einer "Sperrschichtkörnung" ausgeformt.

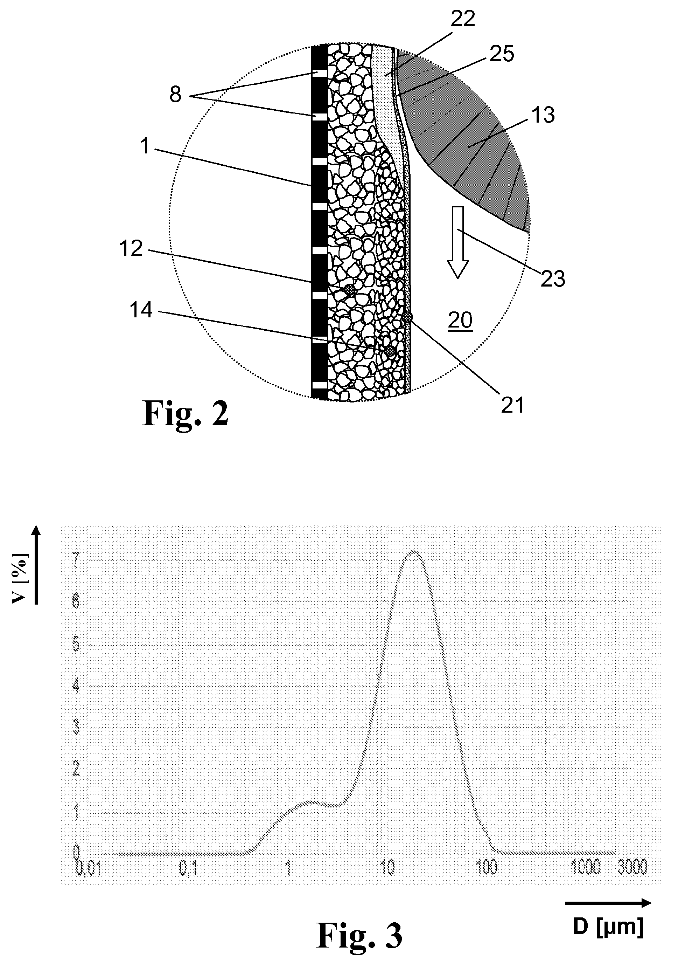

**Figur 3** zeigt eine typische Teilchengrößenverteilung der hierfür eingesetzten Sperrschichtkörnung. Auf der y-Achse des Diagramms ist der Volumenanteil V (in %) der Körnung aufgetragen, auf der x-Achse der Teilchendurchmesser D (in µm). Die Sperrschichtkörnung besteht aus sphärischen, synthetisch erzeugten SiO₂-Teilchen, die sich durch eine mehrmodale Teilchengrößenverteilung mit einem verhältnismäßig engen Maximum der Größenverteilung bei etwa 15 µm (D₅₀-Wert) auszeichnen. Ein Nebenmaximum liegt im Bereich um 2 µm. Die Sperrschichtkörnung wird vorab in einem Heißchlorierverfahren gereinigt. Der Verunreinigungsgehalt der gereinigten Sperrschichtkörnung ist gering und liegt insgesamt bei weniger als 1 Gew.-ppm.

Wegen der geringen Teilchengröße und der damit einhergehenden hohen Fluidität der Sperrschichtkörnung sind Maßnahmen zur Fixierung der Sperrkörnungsschicht 16 erforderlich. Zum einen wird vor dem Ausformen der Sperrkörnungsschicht 16 die Innenkörnungsschicht 14 mit Wasser besprüht und dadurch angefeuchtet. Daraufhin wird das Hitzeschild 2 über der Öffnung der Schmelzform 1 positioniert und vor dem Zünden des Plasmas 13 über den Einlass 9 Wasserdampf zur Befeuchtung der Sperrkörnungsschicht 16 in den Tiegel-Innenraum eingelassen. Auf diese Weise wird auch die Sperrkörnungsschicht 16 zusätzlich in ihrer Form fixiert.

In einem weiteren Verfahrensschritt erfolgt das Verglasen der Körnungsschichten 12, 14 und 16. Die Elektroden 5; 6 werden durch die zentrale Öffnung des Hitzeschildes 2 in den Innenraum 20 eingeführt und zwischen den Elektroden 5; 6 ein Lichtbogen gezündet, der in Figur 1 durch die Plasmazone 13 als grau hinterlegter Bereich gekennzeichnet ist. Gleichzeitig wird an der Außenseite der Schmelzform 1 ein Vakuum angelegt, das aber wegen der porösen SiO₂-Körnungsschichten 12, 14; 16 bis in den Innenraum 20 der Schmelzform 1 durchgreift, so dass in diesem Verfahrensstadium kein ausreichend hohes Vakuum erreichbar ist.

Zum Verglasen der Körnungsschichten 12; 14; 16 wird ein dreistufiger Verglasungsprozess angewandt. In der ersten Verglasungsstufe werden die Elektroden 5; 6 in eine zentrale Position des Innenraums 20 verbracht und mit einer Leistung von etwa 270 kW (200 V, 1350 A) beaufschlagt. Die dadurch erzeugte Hitze im Innenraum 20 genügt zum Sintern der besonders sinteraktiven Teilchen der Sperrkörnungsschicht 16 und es bildet sich sehr schnell und gleichmäßig über die gesamte Tiegel-Innenwandung eine lückenlose dichte Versiegelungsschicht 21 (siehe Figur 2), welche zwar blasenhaltig ist. jedoch die nicht verschmolzenen Anteile der Tiegelwandung von der Atmosphäre im Schmelzform-Innenraum 20 trennt. Die Dicke der Versiegelungsschicht ergibt sich bei gegebener Leistung des Plasmas 13 aufgrund der zum vollständigen Versiegeln erforderlichen Heizdauer. Diese ist beim erfindungsgemäßen Verfahren etwa halb so lang wie beim Verfahren nach dem Stand der Technik, so dass sich auch nur etwa halb so starke Versiegelungsschicht 21 ausbildet.

Sobald die Sperrkörnungsschicht 16 vollständig verschmolzen und eine geschlossene Versiegelungsschicht 21 ausgebildet ist, beginnt die zweite Verglasungsstufe. Da weiterhin über die Vakuumeinrichtung 17 abgepumpt wird, entsteht in der noch nicht verglasten Außenkörnungsschicht 12; 14 ein Unterdruck von etwa 200 mbar (absolut). Die Elektroden 5; 6 werden nun mit einer Leistung von 600 kW (300 V, 2000 A) beaufschlagt und zusammen mit dem Hitzeschild 2 in die in Figur 1 gezeigte seitliche Position gebracht, um die Körnungsschichten 12; 14 im Bereich der Seitenwandung zu verglasen.

Diese Verglasungsstufe wird anhand in **Figur 2****,** die einen Vergrößerung von Ausschnitt "A" der Tiegelwandung zeigt, näher erläutert. Nach Fertigstellung der gleichmäßig dicken, blasigen aber dichten Versiegelungsschicht 21 liegt der Unterdruck im Bereich der Körnungsschichten 12, 14 bei etwa 200 mbar (absolut) und die Elektroden 5; 6 werden mit einer Leistung von 600 kW beaufschlagt. Die Plasmazone 13 wird langsam nach unten bewegt, wie der Richtungspfeil 23 andeutet und dabei die Innenschichtkörnung 14 kontinuierlich und bereichsweise zu einer blasenfreien Innenschicht 22 erschmolzen. Die Gleichmäßigkeit und geringe Dicke der vorab erzeugten Versiegelungsschicht 21 trägt dazu bei, dass auch die Dicke der Innenschicht 22 im Wesentlichen konstant ist. Während des Verglasens wird die blasenhaltige Versiegelungsschicht 21 unter der Wirkung des Plasmas 13 teilweise abgebrannt, so dass davon nur noch ein dünner Film 25 mit einer Dicke von weniger als 1 mm übrig bleibt.

Zum Verglasen der Körnungsschichten 12; 14 im Bereich des Bodens werden Hitzeschild 2 und Elektroden 5; 6 in eine zentrale Position gebracht und die Elektroden 5; 6 nach unten abgesenkt.

Infolge des höheren Vakuums nach der Ausbildung der Versiegelungsschicht 21 bildet sich beim Verglasen der Körnungsschichten 12; 14 unterhalb der Versiegelungsschicht 21 eine dichte, blasenarme und daher transparente Innenschicht 22 aus der Innenkörnungsschicht 14.

Sobald die transparente Innenschicht 22 eine Dicke von etwa 2,5 mm erreicht hat, wird in der dritten Verglasungsstufe die Saugleistung der Vakuumeinrichtung 17 über ein Drosselventil (in Figur 1 nicht dargestellt) so verringert, dass der Druck in den noch nicht verglasten Bereichen der Körnungsschichten 12; 14 auf 900 mbar (Absolutdruck) ansteigt. Das hierzu benötigte Gas kommt insbesondere aus dem Innenraum 20 der Schmelzform 1, aus der es durch nicht verschmolzene Bereiche der Körnungsschichten 12; 14 über die Öffnungen 8 der Formwandung austritt.

Der Schmelzvorgang wird beendet, bevor die Schmelzfront die Innenwandung der Schmelzform 1 erreicht.

Die dünne, nicht transparente Versiegelungsschicht, die die transparente Innenschicht überzieht, wird während der zweiten und dritten Verglasungsstufe durch die Einwirkung des Plasmas 13 zumindest teilweise abgebrannt. Etwaige Reste werden am Ende des Herstellungsprozesses durch chemisches Ätzen vollständig beseitigt. Die innere Oberfläche des so hergestellten Quarzglastiegels wird somit von einer glatten, blasenarmen und gleichmäßig dicken Innenschicht 22 aus synthetischem SiO₂ gebildet, die mit einer Außenschicht aus opakem Quarzglas fest verbunden ist. Die so erzeugte Innenschicht 22 zeichnet sich außerdem durch ein geringes Blasenwachstum beim bestimmungsgemäßen Einsatz des Tiegels aus.

## Patentansprüche

1. Verfahren zur Herstellung eines Quarzglastiegels zum Ziehen eines Einkristalls, das folgende Verfahrensschritte umfasst:
(a) Bereitstellen einer Schmelzform (1) mit einer Wandung, die eine Innenseite, eine Außenseite und durchgehende Löcher (8) zwischen Außenseite und Innenseite aufweist,
(b) Bereitstellen einer Außenschichtkörnung aus ersten, gröberen SiO₂-Teilchen und Ausbilden einer Außenkörnungsschicht (12; 14) aus der Außenschichtkörnung an der Innenseite der Schmelzform-Wandung,
(c) Bereitstellen einer Sperrschichtkörnung aus zweiten, feineren SiO₂-Teilchen und Erzeugen einer Sperrkörnungsschicht (16) aus der Sperrschichtkörnung auf der Außenkörnungsschicht, mit einer Maßnahme zur Fixierung der Sperrschichtkörnung (16) auf der Außenschichtkörnung (12; 14),
(d) Anlegen eines Unterdrucks (17) an der Außenseite der Schmelzform-Wandung,
(e) Erhitzen der Sperrkörnungsschicht (16) und der Außenkörnungsschicht (12; 14) unter Bildung eines Quarzglastiegels mit transparenter Innenschicht (22),
**dadurch gekennzeichnet, dass** die SiO₂-Teilchen der Sperrschichtkörnung eine mittlere Teilchengröße (D₅₀-Wert) von weniger als 30 µm aufweisen und dass das Ausbilden der Sperrkörnungsschicht (16) die Maßnahme zur Fixierung der Sperrschichtkörnung auf der Außenkörnungsschicht (12; 14) ein Anfeuchten der Außenkörnungsschicht (12; 14) vor oder beim Erzeugen der Sperrkörnungsschicht (16) und/oder ein Anfeuchten der Sperrschichtkörnung umfasst.

2. Verfahren nach Anspruch 1, **dadurch gekennzeichnet, dass** die SiO₂-Teilchen der Sperrschichtkörnung eine mittlere Teilchengröße (D₅₀-Wert) von weniger als 20 µm aufweisen.

3. Verfahren nach Anspruch 1 oder 2, **dadurch gekennzeichnet, dass** die SiO₂-Teilchen der Außenschichtkörnung eine mittlere Teilchengröße (D₅₀-Wert) von mehr als 100 µm, vorzugsweise eine mittlere Teilchengröße (D₅₀-Wert) von mehr als 120 µm, aufweisen.

4. Verfahren nach einem der vorhergehenden Ansprüche, **dadurch gekennzeichnet, dass** die SiO₂-Teilchen der Sperrschichtkörnung eine mehrmodale Teilchengrößenverteilung aufweisen, mit einem ersten Maximum der Größenverteilung im Bereich von 0,03 bis 2 µm und einem zweiten Maximum im Bereich von 3 bis 50 µm.

5. Verfahren nach einem der vorhergehenden Ansprüche, **dadurch gekennzeichnet, dass** der Sperrschichtkörnung ein die Viskosität von Quarzglas verringernder Dotierstoff zugesetzt wird.

6. Verfahren nach einem der vorhergehenden Ansprüche, **dadurch gekennzeichnet, dass** zum Anfeuchten Wasserdampf eingesetzt wird.

7. Verfahren nach einem der Ansprüche 1 bis 5, **dadurch gekennzeichnet, dass** zum Anfeuchten eine wasserfreie Flüssigkeit eingesetzt wird.

8. Verfahren nach einem der vorhergehenden Ansprüche, **dadurch gekennzeichnet, dass** die Maßnahme zur Fixierung der Sperrschichtkörnung ein Aufbringen von Sperrschichtkörnung auf einem flexiblen, flächigen Hilfskörper und ein Fixieren auf dem Hilfskörper umfasst, der anschließend mit der darauf fixierten Sperrschichtkörnung auf die Außenkörnungsschicht aufgelegt wird.

9. Verfahren nach einem der vorhergehenden Ansprüche, **dadurch gekennzeichnet, dass** das Erhitzen gemäß Verfahrensschritt (e) einen zweistufigen Heizprozess umfasst, mit einer ersten Heizstufe, während der die Sperrkörnungsschicht (16) bei niedrigerer Temperatur verglast wird, und mit einer zweiten Heizstufe, während der die Außenkörnungsschicht (12; 14) bei höherer Temperatur erhitzt und dabei mindestens teilweise gesintert wird.

10. Verfahren nach Anspruch 9, **dadurch gekennzeichnet, dass** der Übergang von der ersten zur zweiten Heizstufe nach dem vollständigen Verglasen der Sperrkörnungsschicht (16) erfolgt.

11. Verfahren nach einem der vorhergehenden Ansprüche, **dadurch gekennzeichnet, dass** die Sperrkörnungsschicht (16) mit einer Schichtdicke im Bereich von 0,3 mm bis 5 mm, vorzugsweise mit einer Schichtdicke von weniger als 3 mm, erzeugt wird.

12. Verfahren nach einem der vorhergehenden Ansprüche, **dadurch gekennzeichnet, dass** eine auf der Oberfläche der transparenten Innenschicht (22) vorhandene blasenhaltige SiO₂-Versiegelungsschicht (21; 25) durch Abbrennen mittels Plasma entfernt wird.

## Claims

1. A method of producing a quartz glass crucible for pulling a single crystal, the method comprising the following steps:
(a) providing a melting mold (1) comprising a wall having an inside, an outside and continuous holes (8) between outside and inside;
(b) providing an outer layer grain consisting of first, coarser SiO₂ particles and forming an outer granulation layer (12; 14) from the outer layer granulation on the inside of the melting mold wall;
(c) providing a barrier layer granulation consisting of second, finer SiO₂ particles and forming a barrier granulation layer (16) from the barrier layer granulation on the outer granulation layer, with a measure for fixing the barrier granulation layer (16) to the outer granulation layer (12; 14)
(d) applying a negative pressure (17) from the outside to the inside of the melting mold wall;
(e) heating the barrier granulation layer (16) and the outer granulation layer (12; 14) so as to form a quartz glass crucible with transparent inner layer (22),
**characterized in that** the SiO₂ particles of the barrier layer granulation have a mean particle size (D₅₀ value) of less than 30 µm and that the formation of the barrier granulation layer (16) comprises the measure for fixing the barrier granulation layer to the outer granulation layer (12; 14) before or during formation of the barrier granulation layer (16) and/or wetting the barrier granulation layer.

2. The method according to claim 1, **characterized in that** the SiO₂ particles of the barrier layer granulation have a mean particle size (D₅₀ value) of less than 20 µm.

3. The method according to claim 1 or 2, **characterized in that** the SiO₂ particles of the outer layer granulation have a mean particle size (D₅₀ value) of more than 100 µm, preferably a mean particle size (D₅₀ value) of more than 120 µm.

4. The method according to any one of the preceding claims, **characterized in that** the SiO₂ particles of the barrier layer granulation have a multimodal particle size distribution, with a first maximum of the size distribution in the range of from 0.03 µm to 2 µm and a second maximum in the range of from 3 µm to 50 µm.

5. The method according to any one of the preceding claims, **characterized in that** a dopant which reduces the viscosity of quartz glass is added to the barrier layer granulation.

6. The method according to any of the preceding claims, **characterized in that** water vapor is used for wetting.

7. The method according to one of the claim1 1 to 5, **characterized in that** a water-free liquid is used for wetting.

8. The method according to any one of the preceding claims, **characterized in that** the measure for fixing the barrier layer granulation comprises applying barrier layer granulation to a flexible flat auxiliary body and fixing on the auxiliary body which is subsequently placed with the barrier layer granulation fixed thereto on the outer granulation layer.

9. The method according to any one of the preceding claims, **characterized in that** heating according to method step (e) comprises a two-stage heating process, with a first heating stage during which the barrier granulation layer (16) is vitrified at a low temperature, and with a second heating stage during which the outer granulation layer (12; 14) is heated at an elevated temperature and is thereby sintered at least in part.

10. The method according to claim 11, **characterized in that** the transition from the first to the second heating stage takes place after complete vitrification of the barrier granulation layer (16).

11. The method according to any one of the preceding claims, **characterized in that** the barrier granulation layer (16) is formed at a layer thickness ranging from 0.3 mm to 5 mm, preferably with a layer thickness of less than 3 mm.

12. The method according to any one of the preceding claims, **characterized in that** a bubble-containing SiO₂ sealing layer (21; 25) which is present on the surface of the transparent inner layer (22) is removed by burning off by means of plasma.

## Revendications

1. Procédé de fabrication d'un creuset en verre de quartz pour tirage d'un monocristal, comprenant les étapes de procédé suivantes:
(a) Préparation d'un moule de fusion (1) présentant une paroi comportant un côté interne, un côté externe et des trous continus (8) entre le côté externe et le côté interne,
(b) Préparation d'une granulation de couche externe à partir de premières particules de SiO₂ plus grossières et formation d'une couche de granulation externe (12; 14) à partir de la granulation de couche externe sur le côté interne de la paroi du moule de fusion,
(c) Préparation d'une granulation de couche de blocage à partir de deuxièmes particules de SiO₂ plus fines et production d'une couche de granulation de blocage (16) à partir de la granulation de couche de blocage sur la couche de granulation de couche externe avec une mesure prise pour fixer la granulation de couche de blocage (16) sur la granulation de couche externe (12; 14),
(d)Application d'une dépression (17) sur le côté externe de la paroi du moule de fusion,
(e)Chauffage de la couche de granulation de blocage (16) et de la couche de granulation externe (12; 14) en format un creuset en verre de quartz avec une couche interne transparente (22),
**caractérisé en ce que** les particules de SiO₂ de la granulation de couche de blocage présentent une taille de particule moyenne (valeur D₅₀) inférieure à 30 µm que la formation de la couche de granulation de blocage (16) englobe une mesure consistant à fixer la granulation de couche de blocage sur la couche de granulation externe (12; 14), l'humectage de la couche de granulation externes (12; 14) avant ou lors de la production de la couche de granulation de blocage (16) et/ou l'humectage de la granulation de couche de blocage.

2. Procédé selon la revendication 1, **caractérisé en ce que** les particules de SiO₂ de la granulation de couche de blocage présentent une taille de particule moyenne (valeur D₅₀) inférieure à 20 µm.

3. Procédé selon la revendication 1 ou la revendication 2, **caractérisé en ce que** les particules de SiO₂ de la granulation de couche externe présentent une taille de particule moyenne (valeur D₅₀) supérieure à 100 µm, de préférence une taille de particule moyenne (valeur D₅₀) supérieure à 120 µm.

4. Procédé selon l'une quelconque des revendications précédentes, **caractérisé en ce que** les particules de SiO₂ de la granulation de couche de blocage présentent une distribution de tailles de particules multimodale, avec un premier maximum de distribution de tailles dans la fourchette de 0,03 à 2 µm et un deuxième maximum dans la fourchette de 3 à 50 µm.

5. Procédé selon l'une quelconque des revendications précédentes, **caractérisé en ce que** l'on ajoute à la granulation de couche de blocage une substance de dopage réduisant la viscosité du verre de quartz.

6. Procédé selon l'une quelconque des revendications précédentes, **caractérisé en ce que** l'on ajoute de vapeur d'eau pour l'humectage.

7. Procédé selon l'une des revendications 1 à 5, **caractérisé en ce que** l'on ajoute un liquide anhydre pour l'humectage.

8. Procédé selon l'une quelconque des revendications précédentes, **caractérisé en ce que** la mesure consistant à fixer la granulation de couche de blocage englobe l'application de la granulation de couche de blocage sur un corps auxiliaire flexible et plan et la fixation sur le corps auxiliaire, que l'on va ensuite déposer sur la couche de granulation externe avec la granulation de couche de blocage fixée sur celle-ci.

9. Procédé selon l'une quelconque des revendications précédentes, **caractérisé en ce que** le chauffage selon l'étape (e) englobe un processus de chauffage en deux temps, avec une première étape de chauffage, pendant laquelle la couche de granulation de blocage (16) est vitrifiée à basse température et une deuxième étape de chauffage, pendant laquelle la couche de granulation externe (12; 14) est portée à une température plus élevée et subit un frittage au moins partiel.

10. Procédé selon la revendication 9, **caractérisé en ce que** la transition de la première étape de chauffage à la deuxième étape de chauffage se produit après la vitrification complète de la couche de granulation de blocage (16).

11. Procédé selon l'une quelconque des revendications précédentes, **caractérisé en ce que** la couche de granulation de blocage (16) est produite avec une épaisseur de couche de l'ordre de 0,3 mm à 5 mm, de préférence une épaisseur de couche inférieure à 3 mm.

12. Procédé selon l'une quelconque des revendications précédentes, **caractérisé en ce que** l'on élimine une couche de scellement (21; 25) de SiO₂ contenant des bulles et présente à la surface de couche interne transparente (22) par brûlage au plasma.
